**Europäisches Patentamt**

**European Patent Office**

**Office européen des brevets**

(19)

(11) Veröffentlichungsnummer : **0 028 022**
**B1**

(12) **EUROPÄISCHE PATENTSCHRIFT**

(45) Veröffentlichungstag der Patentschrift :
06.05.87

(51) Int. Cl.⁴ : **H 01 L 27/14**

(21) Anmeldenummer : 80106541.8

(22) Anmeldetag : 24.10.80

(54) **Infrarotempfindlicher x-y-CCD-Sensor und Verfahren zu seiner Herstellung.**

(30) Priorität : 25.10.79 DE 2943143

(43) Veröffentlichungstag der Anmeldung :
06.05.81 Patentblatt 81/18

(45) Bekanntmachung des Hinweises auf die Patenterteilung : 06.05.87 Patentblatt 87/19

(84) Benannte Vertragsstaaten :
FR GB

(56) Entgegenhaltungen :
EP-A- 0 003 130
US-A- 3 770 988
US-A- 4 142 198
US-A- 4 155 094

(73) Patentinhaber : **Siemens Aktiengesellschaft Berlin und München**
**Wittelsbacherplatz 2**
**D-8000 München 2 (DE)**

(72) Erfinder : **Risch, Lothar, Dr.**
**Gartenstrasse 20 b**
**D-8012 Ottobrunn (DE)**
Erfinder : **Mader, Hermann, Dr.**
**Carl-Duisberg-Strasse 42**
**D-8025 Unterhaching (DE)**

## Beschreibung

Die vorliegende Patentanmeldung betrifft einen infrarotempfindlichen x-y-CCD-Sensor gemäß dem Oberbegriff des Patentanspruchs 1.

Zum Nachweis und zur Messung infraroter Strahlen werden Sensoren verwendet, die nach dem Prinzip des inneren Fotoeffekts arbeiten. Dabei geschieht der Strahlungsnachweis durch die Wechselwirkung von Strahlung und Elektronen im Gitterverband. Energiequanten der auf den Sensor fallenden Strahlung heben Elektronen im Gitterverband. Energiequanten der auf den Sensor fallenden Strahlung heben Elektronen auf ein höheres Energieniveau an. Nach der Quantentheorie ist die Strahlungsenergie umgekehrt proportional zur Wellenlänge.

Bei extrinsischen Silizium wird die Fotoleitung bei Photonenenergien kleiner Bandabstand durch Ionisation von Fremdatomen verursacht. Bei derartigen Halbleitern ist nicht der Bandabstand, sondern die sogenannte Ionisierungsenergie der Donatoren bzw. Akzeptoren für die Grenzwellenlänge verantwortlich. Für den Wellenlängenbereich von 8 bis 12 $\mu$m verwendet man zur Zeit Silizium mit einer Galliumdotierung, für den Wellenlängenbereich von 3 bis 5 $\mu$m Silizium mit einer Indium- oder Thalliumdotierung. Wegen der geringen Ionisierungsenergie tritt bereits bei Zimmertemperatur eine fast vollständige Ionisierung der Fremdatome ein. Das hat zur Folge, daß die Leitfähigkeit solcher Kristalle bereits ohne Bestrahlung sehr hoch ist. Hinzu kommt, daß einfallende Strahlung kaum noch ionisierbare Fremdatome vorfindet, und daher keine messbare Leitfähigkeitserhöhung verursachen kann. Für den Betrieb solcher Sensoren ist daher eine Kühlung, das heißt, ein Betrieb bei niedrigen Temperaturen wie der des flüssigen Stickstoffs oder Heliums unerlässlich, was für den Anwender häufig nicht akzeptierbar ist und derartige Sensoren extrem verteuert.

Aus der US-A-4 142 198 ist ein Infrarotempfindlicher CCD-Sensor bekannt der aus der Kombination einer CCD-Anordnung mit einen Infrarotsensorelement besteht.

Aus dem IEDM-Tagungsbericht 1978, Seite 496 bis 500 ist aus einem Aufsatz von D.D. Buss u.a. ein infrarotempfindliches CCD zu entnehmen, welches als lichtempfindliches Element Verbindungshalbleiter mit kleinem Bandabstand, insbesondere Quecksilber-Cadmium-Tellurid-Kristalle (Hg-Cd-Te) verwendet. Auch hier wird zur Kühlung flüssige Luft benötigt. Die Herstellung eines solchen Bauelements aus Sensor und CCD aus Verbindungshalbleitern ist äußerst schwierig und erfordert einen erheblichen technologischen Aufwand. Nur bei Quecksilber-Cadmium-Tellurid gelang es bisher, CCD's mit Übertragungsverlusten $\varepsilon = 5 \times 10^{-4}$ herzustellen. Bei den anderen, in diesem Aufsatz beschriebenen Materialien wie Indiumantimonid, Gallium-Indium-Antimonid, Bleitellurid und Blei-Zinn-Tellurid sind die Übertragungsverluste für praktische Anwendungen zu groß.

Die Aufgabe, die der Erfindung zugrundeliegt, besteht nun darin, einen x-y-CCD-Sensor mit guter Infrarotempfindlichkeit zu schaffen, der

a) im Wellenlängenbereich von 3 bis 5 $\mu$m und 8 bis 12 $\mu$m empfindlich ist,

b) in einfacher Technologie herstellbar ist,

c) durch seine Bauart eine hohe Integrationsdichte gewährleistet und

d) auch in seiner Anwendung unproblematisch ist, das heißt, bei Zimmertemperatur oder durch Kühlung mit Peltierelementen betrieben werden kann, so daß eine Kühlung im Bereich von flüssiger Luft nicht unbedingt erforderlich ist.

Diese Aufgabe wird durch die im kennzeichnenden Teil des Anspruchs 1 aufgeführten Merkmale gelöst.

Es liegt im Rahmen der Erfindung, daß die Anordnung in Doppel-Poly-Silizium-Technologie hergestellt ist und daß die Diode mit der 3-Schichten-Struktur eine mittlere, als Basis wirkende Schicht aufweist, die bezüglich ihrer Dicke so dünn gewählt ist, daß bei der gegebenen Dotierung dieser Schicht der Bereich dieser Schicht schon ohne angelegte Spannung an freien Ladungsträgern verarmt ist. Gemäß einem Ausführungsbeispiel nach der Lehre der Erfindung ist die Dicke der mittleren Schicht kleiner als 75 nm.

In einer Weiterbildung des Erfindungsgedankens ist vorgesehen, die Schichten der Diode durch Ionenimplantation mit Phosphor und Bor herzustellen, wobei für die Dotierungsdichte der Schichtenfolge gilt: $N_E > N_B > N_C$, worin $N_E$, $N_B$, $N_C$ die Dotierungsdichten der als Emitter, als Basis und als Kollektor wirksamen Schicht sind. Eine solche Diode ist auch in der DE-A-28 00 820 beschrieben.

Durch die Anwendung dieser Diode in der erfindungsgemäßen Anordnung sind nur drei zusätzliche Implantationsschritte bei der Herstellung erforderlich. Die Kühlung erfolgt elektrisch mit Peltier-Elementen. Elemente dieser Art sind käuflich zu erwerben. Wird durch die Verbindungsstelle zweier metallischer Leiter ein elektrischer Strom geschickt, so tritt bei geeigneter Stromrichtung eine Abkühlung bis zu $-30\,°C$ auf.

Weitere Einzelheiten über die Wirkungsweise der Anordnung sowie über deren Herstellung sind den Figuren 1 bis 6 zu entnehmen. Dabei zeigt

die Figur 1 im Bändermodell die Wirkungsweise der $n^+$ pn-Diode,

die Figur 2 einen Querschnitt durch das Sensorelement mit dem Verlauf des Oberflächenpotentials und

die Figur 3 in Draufsicht eine eindimensionale Sensor-Schaltung und

die Figuren 4 und 5 zeigen Verfahrenschritte zur Herstellung der erfindungsgemäßen Anordnung und

die Figur 6 zeigt die Dotierungsprofile der n⁺, p, n Schichten.

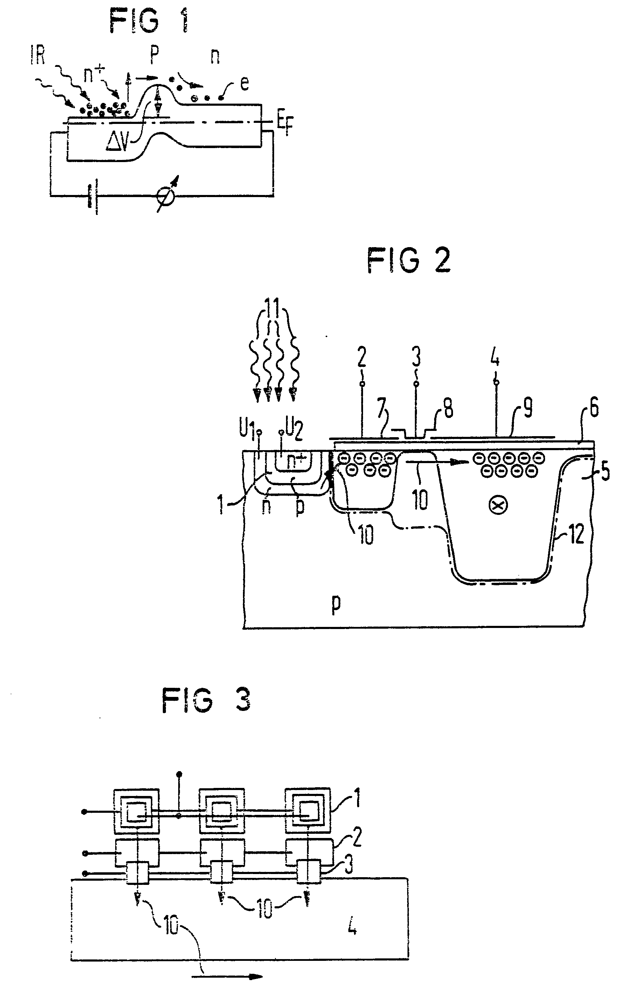

Figur 1 : Mit einer n⁺-pn-Struktur wird eine Potentialschwelle erzeugt, deren Höhe $\Delta V$ und Breite durch Dotierung, Geometrie und angelegte Spannung einstellbar ist. Dabei bedeutet die Linie $E_F$ das Fermi-Niveau. Ohne Belichtung stellt sich ein Gleichgewicht der Elektronenströme von n⁺- zum n-Gebiet ein. Wird das System mit Infrarot (IR) bestrahlt, so fließt durch freie Ladungsträgerabsorption im n⁺-Gebiet (höchste Konzentration) ein zusätzlicher Elektronenstrom e über die Barriere (siehe Pfeile).

Diese Ladungsträger werden, wie aus Figur 2 ersichtlich ist, nach folgendem Prinzip in das SCCD (= surface-charge-coupled-device = Oberflächenladungsgekoppeltes Bauelement) eingegeben : Die in n⁺pn-Struktur aufgebaute Diode 1 wird in vertikaler Richtung angelegt. Unmittelbar an das n-Gebiet grenzt eine MOS-Speicherelektrode 2, die elektrisch geeignet getaktet wird und die durch die IR-Bestrahlung erzeugten Elektronen $\ominus$ des Sensors integriert. Mit einem weiteren getakteten Transfergate 3 wird diese Ladung dann in die CCD-Kette 4 eingegeben. Der CCD-Schaltkreis 4 besitzt eine 2-Lagen-Struktur, die mit den herkömmlichen Mitteln der MOS-Technik hergestellt wird. Durch Oxidation der Halbleiteroberfläche ergibt sich ein dünner Isolator 6, auf dem die Elektroden 7, 8, 9 aufgebracht werden. Die Funktionsweise der CCD-Technik entspricht einer Hintereinanderschaltung von Kondensatoren, bei der eine am Anfang der Kette eingegebene Information durch entsprechendes Takten von einem Kondensator zum anderen weitergeschoben wird. Die Pfeile 10 in Figur 2 markieren den Ladungstransport, die Pfeile 11 den Lichteinfall. Die Linie 12 zeigt den Potentialverlauf an, dabei betrifft die durchgezogene Linie den Speichervorgang, die strichpunktierte Linie den Auslesevorgang. Das Symbol $\otimes$ soll den Ladungstransport senkrecht zur Bildebene anzeigen.

Aus Figur 3 ist der Aufbau eines eindimensionalen Sensors zu entnehmen. Dabei gelten die gleichen Bezugszeichen wie in Figur 2.

Nach dem gleichen Prinzip wie ein CCD-Sensor mit MOS-Kondensatoren kann dann der zweidimensionale Sensor hergestellt werden.

Mit der erfindungsgemäßen Anordnung können Übertragungsverluste der CCD's von $\varepsilon$ 2 $\times 10^{-5}$ erhalten werden. Dies ermöglicht die Herstellung sehr großer Sensoren mit hoher Ausbeute. Das Problem der Kühlung wird elektrisch mit Peltier-Elementen gelöst.

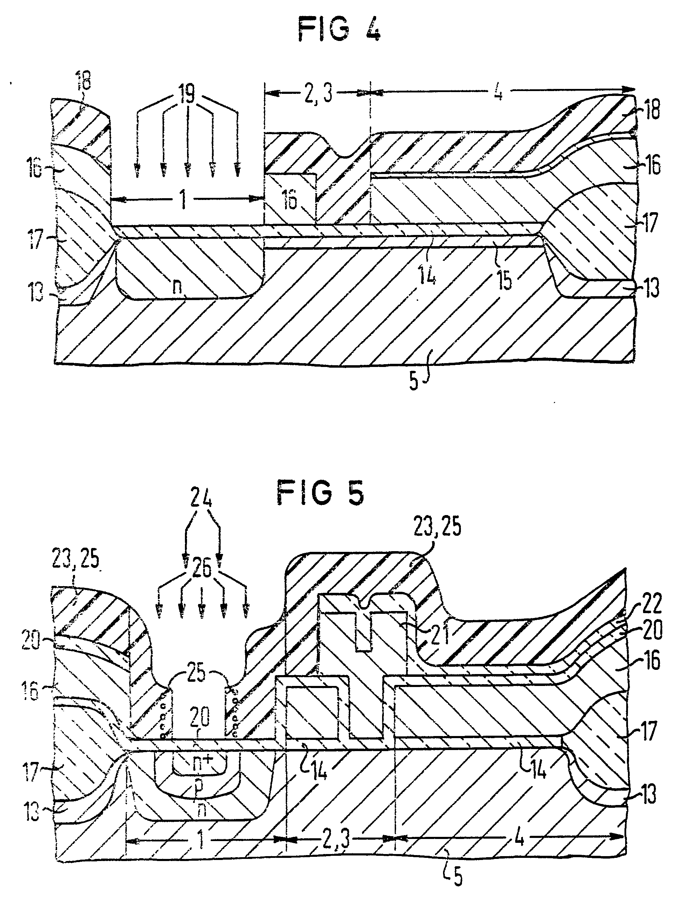

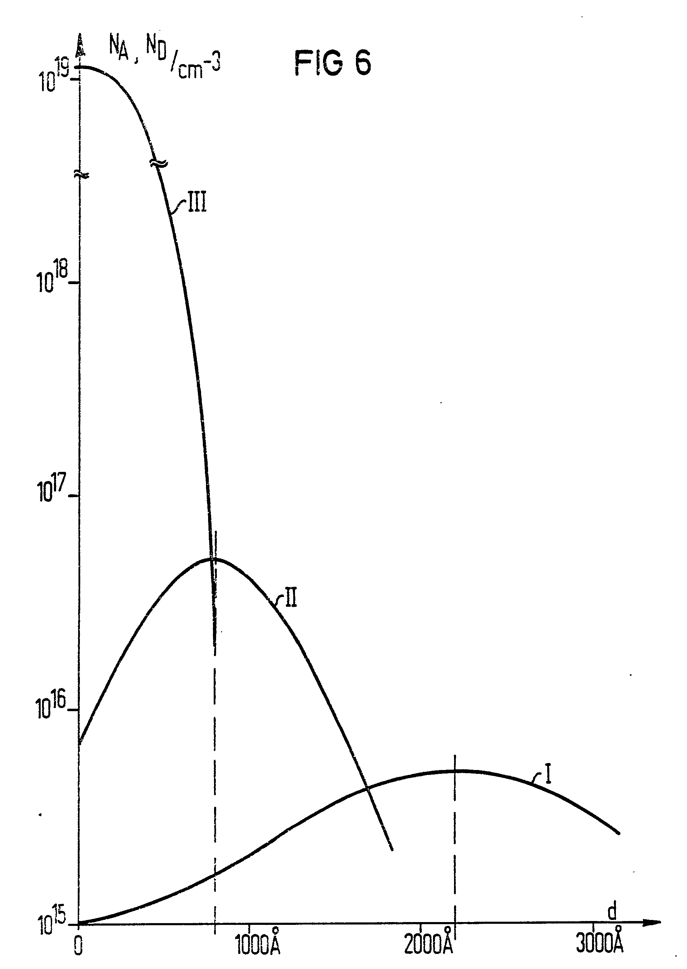

Der große Vorteil der erfindungsgemäßen Anordnung gegenüber den bekannten Vorrichtungen liegt aber insbesondere in seiner einfachen Art der Herstellung. Im folgenden sollen anhand der Figuren 4 und 5 die einzelnen Verfahrensschritte zur Herstellung des CCD-Sensors mit npn-Dioden beschrieben werden. Die Figur 6 zeigt die Implantationsprofile der n⁺pn-Dioden. Dabei ist als Abszisse die Eindringtiefe d und als Ordinate die Trägerkonzentration $N_A$, $N_D$ aufgetragen.

Figur 4 zeigt eine Anordnung im Schnittbild, bei der die ersten bereits bekannten Prozeßschritte des Doppel-Poly-Silizium-Prozesses wie Maskieroxidation 17, Rückseitenätzung, Getterung, Nitridabscheidung, Feldimplantation 13, Locos-Maske entfernen, Gateoxidation —1 ($\sim$ 500 Å) 14, Kanalimplantation 15, Poly-Silizium-1-Abscheidung 16, Poly-Silizium-1-Dotierung, Maskierung und Poly-Silizium-1-Ätzen bereits erfolgt sind. Auf diese Verfahrensschritte soll hier nicht näher eingegangen werden.

Zusätzlich nur übrigen CCD-Struktur wurden bisher nur die Speicherelektrode und das Transfergate vom Sensor in das CCD berücksichtigt.

Mit einer Fotolackmaske 18 wird nun das gesamte Gebiet bis auf die zukünftigen Diodengebiete 1 abgedeckt. Dann wird eine tiefe Implantation (siehe Pfeile 19) des n-Gebietes der Diode 1 durchgeführt, wobei Phosphorionen mit einer Beschleunigungsspannung von 180 keV und einer Bestrahlungsdosis von $10^{10}$ bis $10^{11}$ cm⁻² $\hat{=}$ $10^{15}$ — $10^{16}$ cm⁻³ in das p-dotierte Substrat 5 (2 bis 20 Ohm cm $\hat{=}$ $7 \times 10^{14}$ bis $7 \times 10^{15}$ cm⁻³) eingeschossen werden. Die Fotolackmaske 18 verhindert dabei die Durchimplantation von Phosphor in das CCD-Gebiet (2, 3, 4).

Nach dieser ersten zusätzlicher Maskierung und Implantation wird der Poly-Silizium-Prozeß durch folgende bekannte Verfahrensschritte fortgesetzt :

Gateoxidation-2 (500 Å) 20, Poly-Silizium-2-Abscheidung 21, Poly-Silizium-2-Dotierung, Maskierung und Poly-Silizium-2-Ätzung (wobei die Diodengebiete stehenbleiben). Dann folgt die Source/Drain-Implantation, Reoxidation und Aufbringen des Zwischenoxids 22.

Wie aus Figur 5 ersichtlich ist, erfolgt nun nach dem Freiätzen des Diodengebietes bis auf das Gateoxid-2- (20) das Aufbringen einer zusätzlichen Fotolackmaske 25 zur Definierung des p-Gebietes der Diode 1. Die Fotolackmaske 25 endet an den punktierten Linien über dem Diodengebiet 1. Die Implantation (siehe Pfeile 26) erfolgt mit Bor bei einer Energie von 40 keV. Die Dosis liegt zwischen $10^{11}$ bis $2 \times 10^{13}$ cm⁻² $\hat{=}$ $10^{16}$ bis $2 \times 10^{18}$ cm⁻³.

Mit einer weiteren Fotolackmaske 23 wird das n⁺-Gebiet der Diode 1 definiert. Die Implantation (siehe Pfeile 24) wird mit Phosphor bei 5 — 50 keV mit einer Dosis von $10^{14}$ bis $10^{15}$ cm⁻² $\hat{=}$ $10^{19}$ bis $10^{20}$ cm⁻³ durchgeführt. Die Implantation kann aber auch mit Arsen erfolgen.

Nach diesen zusätzlichen Verfahrensschritten wird die Anordnung durch die restlichen Prozeßschritte der Doppel-Poly-Silizium-Technik wie Temperung des Zwischenoxids, Kontaktlochmaskierung und -ätzung, Aluminium/Kupfer-Silizium-Bedampfung, Leiterbahnätzung, Passivierung und Kontaktierung in bekannter Weise fertiggestellt. Diese Verfahrensschritte sind in der Figur 5 nicht mehr enthalten.

Die für die IR-Empfindlichkeit der Dioden (1) entscheidenden Implantationsprofile sind in Figur 6 dargestellt. Dabei zeigt die Kurve I den Verlauf der Dotierung für das n-Gebiet, die Kurve II das Dotierungsprofil für das p-dotierte Gebiet und die Kurve III das Dotierungsprofil für das $n^+$-Gebiet.

**Patentansprüche**

1. Infrarotempfindliche x-y-CCD-Sensor, bestehend aus der Kombination einer in einem p-dotierten Halbleitersubstrat aus Silizium angeordneten n-Kanal-CCD-Anordnung mit einem Infrarotsensorelement dadurch gekennzeichnet, daß das Infrarotsensorelement aus einer $n^+$pn-Diode mit in vertikaler Richtung im Halbleitersubstrat aufgebauter 3-Schichten-Struktur besteht an deren n-Gebiet unmittelbar die MOS-Speicherelektrode der CCD-Anordnung grenzt, wobei die Diode eine mittlere, als Basis wirkende Schicht aufweist, die bezüglich ihrer Dicke so dünn gewählt ist, daß bei der gegebenen Dotierung dieser Schicht der Bereich dieser Schicht schon ohne angelegte Spannung an freien Ladungsträgern verarmt ist.

2. Anordnung nach Anspruch 1, dadurch gekennzeichnet, daß die Dicke der mittleren Schicht kleiner als 75 nm ist.

3. Anordnung nach Anspruch 1 oder 2, dadurch gekennzeichnet, daß für die Dotierungsdichte der Schichtenfolge gilt : $N_E > N_B > N_C$, worin $N_E$, $N_B$ und $N_C$ die Dotierungsdichten der als Emitter, als Basis und als Kollektor wirksamen Schicht sind.

4. Anordnung nach Anspruch 1 bis 3, dadurch gekennzeichnet, daß das p-leitende Siliziumsubstrat eine Trägerkonzentration im Bereich von 7 $\times$ $10^{14}$ bis 7 $\times$ $10^{15}$ cm$^{-3}$ aufweist.

5. Anordnung nach Anspruch 1 bis 4, dadurch gekennzeichnet, daß die Dotierungsdichte vom Emitter ($n^+$) $10^{19}$ — $10^{20}$ cm$^{-3}$, von der Basis (p) $10^{16}$ — $2 \cdot 10^{18}$ cm$^{-3}$ und vom Kollektor (n) $10^{15}$ — $10^{16}$ cm$^{-3}$ ist.

6. Verfahren zur Herstellung eines infrarotempfindlichen CCD-Sensors nach einem der Ansprüche 1 bis 5, gekennzeichnet durch folgende, zusätzlich zu den bekannten Verfahrensschritten zur Herstellung eines CCD's in Doppel-Poly-Silizium-Technologie durchzuführenden Verfahrensschritte :

a) ganzflächiges Aufbringen einer Fotolackschicht (18) nach Fertigstellung der Poly-Silizium-1-Struktur (16).

b) Entfernen dieser Lackschicht im Bereich der Diodengebiete,

c) Implantation (19) des n-Gebietes mit Phosphor mit einer kinetischen Energie von 180 keV und einer Dosis von $10^{10}$ bis $10^{11}$ cm$^{-2}$

d) Freiätzen des Diodengebietes bis auf das Gate-2-Oxid (20) nach Fertigstellung der Poly-Silizium-2-Struktur (21),

e) Aufbringen einer Fotolackmaske (25) zur Definierung des p-Gebietes

f) Implantation (26) des p-Gebietes mit Bor mit einer kinetischen Energie von 40 keV und einer Dosis von $10^{11}$ bis $2 \times 10^{13}$ cm$^{-2}$

g) Aufbringen einer Fotolackmaske (23) zur Definierung des $n^+$-Gebietes

h) Implantation (24) des $n^+$-Gebietes mit Phosphor mit einer kinetischen Energie von 5-50 keV und einer Dosis von $10^{14}$ bis $10^{15}$ cm$^{-2}$ und

i) Fertigstellung der Anordnung mit Kontakten.

7. Verfahren nach Anspruch 6 dadurch gekennzeichnet, daß anstelle von Phosphor im Verfahrensschritt c Arsen implantiert wird.

**Claims**

1. An infrared-sensitive x-y-CCD sensor, consisting of the combination of an n-channel-CCD arrangement located in a p-doped silicon semiconductor substrate with an infrared sensor element, characterised in that the infrared sensor element consists of a $n^+$pn-diode which has a 3-layer structure formed vertically in the semiconductor substrate and the n-zone of which directly adjoins the MOS-storage electrode of the CCD-arrangement, where the diode comprises a middle layer which acts as base and the thickness of which is selected to be sufficiently thin to ensure that with the given doping of this layer the region of this layer is depleted of free charge carriers even when no voltage is connected.

2. An arrangement as claimed in Claim 1, characterised in that the thickness of the middle layer is less than 75 nm.

3. An arrangement as claimed in Claim 1 or Claim 2, characterised in that the doping density of the layer sequence is governed by :
$N_E$ $N_B$ $N_C$, where $N_E$, $N_B$ and $N_C$ are the doping densities of the layers which act as emitter, base and collector.

4. An arrangement as claimed in Claim 1 to 3, characterised in that the p-conducting silicon substrate has a carrier concentration in the range of from 7 $\times$ $10^{14}$ to 7 $\times$ $10^{15}$ cm$^{-3}$.

5. An arrangement as claimed in Claim 1 to 4, characterised in that the doping density of the emitter ($n^+$) is $10^{19}$ — $10^{20}$ cm$^{-3}$, that of the base (p) is $10^{16}$ — $2 \cdot 10^{18}$ cm$^{-3}$, and that of the collector (n) $10^{15}$ — $10^{16}$ cm$^{-3}$.

6. A process for the production of an infrared-sensitive-CCD sensor as claimed in one of the Claims 1 to 5, characterised by the following process steps which are to be carried out in addition to the known process steps for the production of a CCD in the double-polysilicon-technique :

a) application of a photolacquer layer (18) to the entire surface after the completion of the polysilicon-1-structure (16),

b) removal of this lacquer layer in the region of the diode zones,

c) implantation (19) of the n-zone with phosphorus at a kinetic energy of 180 keV and in a dose of $10^{10}$ to $10^{11}$ cm$^{-2}$,

d) etching away of the diode zone to the gate-2-oxide (20) following the completion of the polysilicon-2-structure (21),

e) application of a photolacquer mask (25) in order to define the p-zone,

f) implantation (26) of the p-zone with boron at a kinetic energy of 40 keV and in a dose of $10^{11}$ to $2 \times 10^{13}$ cm$^{-2}$,

g) application of a photolacquer mask (23) in order to define the n$^+$-zone,

h) implantation (24) of the n$^+$-zone with phosphorus at a kinetic energy of 5-50 keV and in a dose of $10^{14}$ to $10^{15}$ cm$^{-2}$, and

i) completion of the arrangement with contacts.

7. A process as claimed in Claim 6, characterised in that in process step c) arsenic is implanted in place of phosphorus.


**Revendications**

1. Détecteur x-y-CCD sensible au rayonnement infrarouge, constitué par la combinaison d'un dispositif CCD à canal n disposé dans un substrat semiconducteur en silicium de type p, et d'un élément détecteur à infrarouge, caractérisé par le fait que l'élément détecteur à infrarouge est constitué par une diode n$^+$np comportant une structure à trois couches, disposée suivant la direction verticale dans le substrat semiconducteur et dont la région de type n avoisine directement l'électrode de mémoire MOS du dispositif CCD, la diode comportant une couche centrale servant de base et dont l'épaisseur est choisie suffisamment mince pour que, dans le cas du dopage donné de cette couche, la région de cette couche soit déjà appauvrie en porteurs de charge libres, sans l'application d'une tension.

2. Dispositif suivant la revendication 1, caractérisé par le fait que l'épaisseur de la couche médiane est inférieure à 75 nm.

3. Dispositif suivant la revendication 1 ou 2, caractérisé par le fait que pour la densité de dopage de la suite de couches on a : NE > $N_B$ > $N_C$, $N_E$, $N_B$ et $N_C$ étant les densités de dopage des couches agissant en tant qu'émetteur, base et collecteur.

4. Dispositif suivant les revendications 1 à 3, caractérisé par le fait que le substrat en silicium conducteur du type p possède une concentration de porteurs située dans la plage allant de $7 \times 10^{14}$ à $7 \times 10^{15}$ cm$^{-3}$.

5. Dispositif suivant les revendications 1 à 4, caractérisé par le fait que la densité de dopage de l'émetteur (n$^+$) est comprise entre $10^{19}$ et $10^{20}$ cm$^{-3}$, que la densité de dopage de la base (t) est comprise entre $10^{16}$ et $2 \cdot 10^{18}$ cm$^{-3}$ et que la densité de dopage du collecteur (n) est comprise entre $10^{15}$ et $10^{16}$ cm$^{-3}$.

6. Procédé pour fabriquer un détecteur CCD sensible au rayonnement infrarouge suivant l'une des revendications 1 à 5, caractérisé par les phases opératoires suivantes, qui doivent être exécutées en supplément des phases opératoires connues servant à fabriquer un dispositif CCD suivant la technologie à double couche de polysilicium.

a) Dépôt, sur toute la surface, d'une couche de laque photosensible (18) après fabrication de la structure de polysilicium-1 (16),

b) élimination de cette couche de laque dans la zone des régions des diodes,

c) implantation (19) de phosphore dans la région de type n, avec une énergie cinétique de 180 keV à une dose de $10^{10}$ à $10^{11}$ cm$^{-2}$,

d) mise à nu par corrosion de la région de la diode jusqu'à l'oxyde de grille-2 (20) après fabrication de la structure de polysilicium-2 (21),

e) dépôt d'un masque de laque photosensible (25) servant à définir la région de type p,

f) implantation (26) de bore dans la région de type p, avec une énergie cinétique de 40 keV à une dose de $10^{11}$ à $2 \times 10^{16}$ cm$^{-2}$,

g) dépôt d'un masque de laque photosensible (23) pour définir la région de type n$^+$,

h) implantation (24) de phosphore dans la région de type n$^+$, avec une énergie cinétique comprise entre 5 et 50 keV à une dose comprise entre $10^{14}$ et $10^{15}$ cm$^{-2}$, et

i) achèvement de la fabrication du dispositif avec la mise en place de contacts.

7. Procédé suivant la revendication 6, caractérisé par le fait qu'on implante de l'arsenic à la place de phosphore lors de la phase opératoire c.

FIG 1

FIG 2

FIG 3

# FIG 4

# FIG 5

FIG 6